# EUROPEAN PATENT SPECIFICATION

(11) **EP 2 126 924 B1**
(45) Date of publication and mention of the grant of the patent: **24.10.2012**
(21) Application number: 07870044.0
(22) Date of filing: 28.12.2007
(51) Int. Cl.: G11C 5/14

(54) **GENERATION OF ANALOG VOLTAGE USING SELF-BIASED CAPACITIVE FEEDBACK STAGE**
ERZEUGUNG VON ANALOGSPANNUNG UNTER VERWENDUNG VON SELBSTVORGESPANNTER KAPAZITIVER RÜCKKOPPLUNGSSTUFE
GÉNÉRATION D'UNE TENSION ANALOGIQUE EN UTILISANT UNE PHASE DE RÉTROACTION CAPACITIVE À POLARISATION AUTOMATIQUE

(30) Priority: 01.01.2007 US 618917; 01.01.2007 US 618918
(43) Date of publication of application: 02.12.2009
(73) Proprietor: SanDisk Technologies Inc., Plano, Texas 75024 (US)
(72) Inventor: PAN, Feng, Richmond, CA 94803 (US)
(74) Representative: Hitchcock, Esmond Antony
(86) International application number: PCT/US2007/089072
(87) International publication number: WO 2008/083292

(56) References cited:
- US-A- 5 563 504
- US-A- 6 101 118
- US-B1- 6 259 612
- US-B1- 6 288 951
- US-B1- 6 424 585
- US-B2- 6 894 928

## Description

The present application relates to analog voltage generation, and more particularly to low-power generation of many different desired voltages on a nonvolatile memory integrated circuit.

Many portable electronic systems are critically limited by battery life. For example, users do not like heavy cell phones, but users also do not like their cell phones to run out of power and shut down. One way to improve battery life is to increase the energy efficiency of the electronics components in the portable system.

As the constraints of low-power integrated circuits have steadily become tighter, the pressure on voltage management has similarly tightened. Power consumption issues, as well as the normal progress of voltage scaling, push designers toward tighter management of voltages on-chip. Accurate power-valid thresholds, or voltage margins which are dynamically determined in a multi-interface chip, are examples of this.

The availability of power island design techniques also means that reference voltages for the particular needs of a particular power island may be demanded.

Modern nonvolatile memory development is turning into one of the most rapidly advancing areas in the semiconductor industry. Memory cell technology itself continues to advance, even within the general areas However, since the transistor operations are inherently not digital, a variety of reference levels are likely to be needed by memory designs. Thus the capability for generation of secondary analog voltages on chip is important.

The bandgap voltage reference circuit is one of the mainstays of analog electronics, and provides a very reliable on-chip reference. However, this circuit topology, in its many variations, is generally limited to one specific output voltage, and consumes power. It is therefore generally preferable not to use more than one bandgap reference circuit per chip.

The case of a low-power nonvolatile memory module is the convergence of the above requirement. Many different voltages must be made available on chip, and yet static power consumption in the various voltage generation stages is extremely undesirable.

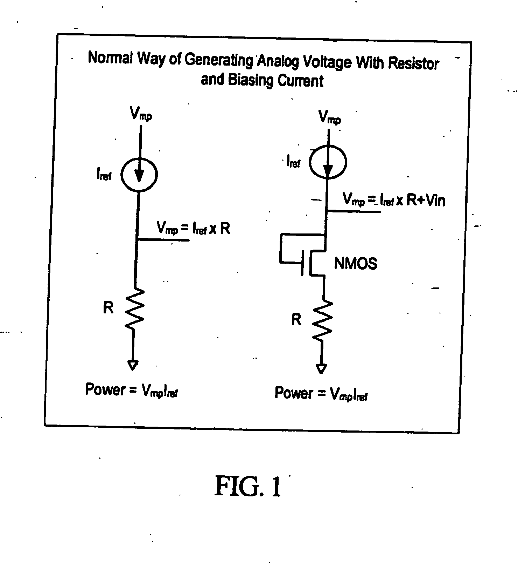

As shown in Figure 1, a current source, mirrored from elsewhere on chip, can be combined with a voltage-drop or ohmic element to give a reference voltage output. However, this approach has a constant power loss of the regulated voltage times the reference current squared.

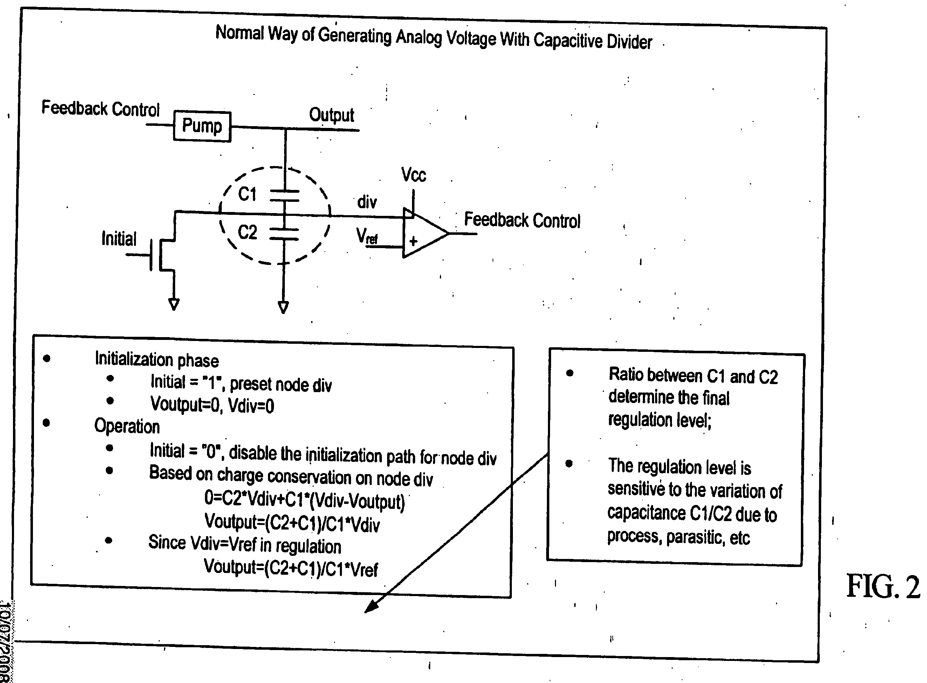

A pending U.S. patent application (US 2008 024096) by the same inventor noted the advantages of a capacitive divider in the feedback loop of a voltage generator circuit. In this example, as illustrated in Figure 2, the op amp shown at the right of the diagram drives the charge pump shown at the top left, to maintain the output at a level which is equal to the reference voltage Vref times the capacitive ratio. Note that this application is NOT necessarily prior art to the present application.

In the circuit of Figure 2, the "div" node is pulled down to ground during the initial phase. After the initial phase the op amp drives the charge pump to make node div equal to Vref, so the output voltage is driven towards Vref times the capacitor ratio (C1 + C2)/C2. Note that the output voltage is directly dependent on the capacitor ratio, so process variation, geometric effects, and parasitic capacitance effects can all affect the output voltage.

The present application discloses a significant improvement to that circuit.

US 5,563,504 discloses a circuit and method according to the preamble of independent claim 6.

US 6,259,612 discloses an internal voltage generator comprising a resistor voltage divider as well as a capacitor voltage divider. The resistor voltage divider is operated so that a current can only flow through it when the internal voltage generator is operating.

US 6,288,951 discloses a non-volatile memory and a method for continuously regulating an output of a charge pump at a target output value for a long period is used.

US 2002/0031032 discloses a circuit comprising serious resistance elements determining a voltage at the base of a drive transistor to suppress an overdriving of the drive transistor.

According to an aspect of the present invention there Is provided a method for controlling a voltage in a circuit comprising an output connection, a differential amplifier and a capacitive divider. The differential amplifier has an inverting input and a non-inverting input and an output. The capacitive divider has a first node in common with the output connection and a second node in common with the inverting input of the differential amplifier. The method comprises. In a first phase, operatively connecting a current-consuming voltage generation stage to the output connection, supplying a reference voltage to the non-inverting input and feeding back an output of the differential amplifier to the inverting input. In a second phase the output of the differential amplifier is directed to the output connection. In the second phase, the current-consuming voltage generation stage is turned off and a voltage is maintained at the output connection by feeding a capacitively divided portion of the voltage from the output connection to the inverting input of the differential amplifier.

According to another aspect of the present invention there is provided a circuit comprising a differential amplifier having a first input, a second input, and an output. The circuit also comprises an output node, a capacitive divider having a first node in common with the output node and a second node in common with the second input. In a first operational phase of the circuit the output is connected to the second Input. The first input is arranged to receive a reference voltage level. In the first operational phase of the circuit the output node is configured to be charged by a pre-charge circuit to an output voltage level. In a second operation phase of the circuit, the pre-charge circuit is shut off. In the first operational phase the differential amplifier is adapted to drive the second node to the reference voltage level. In the second operational phase of the circuit the circuit is configured to maintain a voltage level at the second node at the reference voltage level with feedback from the differential amplifier via the capacitive divider.

The present application discloses new approaches to analog voltage generation using active control without DC current consumption. A conventional leg sets an initial correct voltage value on an output terminal, and a differential stage (e.g. an op amp) is placed in a metastable state at this correct voltage value. The result of this is surprising: the differential stage's connection during startup assures that it will be at its optimal operating point.

The disclosed innovations, in various embodiments, provide one or more of at least the following advantages:
- Reduced static current drain
- More accurate analog voltage generation
- Reduced power consumption
- Simpler system architecture
- Ability to provide a larger number of voltage levels within a given power budget
- Smaller layout. This is possible because the ratio of the capacitors themselves is not as critical in determining the operating poing, according to the present inventions, so it is no longer necessary to use very large capacitors if a precision ratio is required.

The disclosed invention will be described with reference to the accompanying drawings, which show important sample embodiments of the invention and which are incorporated in the specification hereof by reference, wherein:
Figure 1 schematically shows a conventional reference voltage generation stage with large static power consumption.
Figure 2 shows a circuit, having the same inventor as named in the present application, which uses a differential stage to drive an output note to a desired level, which is set by a ratio of capacitors and a reference voltage.
Figure 3 shows a first sample embodiment of a new circuit, in which a conventional stage is used to set the output voltage, while a differential stage self-tunes itself by connection to the correct output voltage. Note that the output node is not necessarily connected to any external load at this time.
Figure 4 shows how two complementary drivers can be used to provide voltage control with a deadband.
Figure 5 shows how an op amp has multiple possible operating curves, depending on the DC offset of that particular op amp; and
Figure 6 shows how the self tuning effect of a circuit like that of Figure 3 sets a desired operating point, and eliminates the bad effects of DC offset and capacitor ratio.

The numerous innovative teachings of the present application will be described with particular reference to presently preferred embodiments (by way of example, and not of limitation).

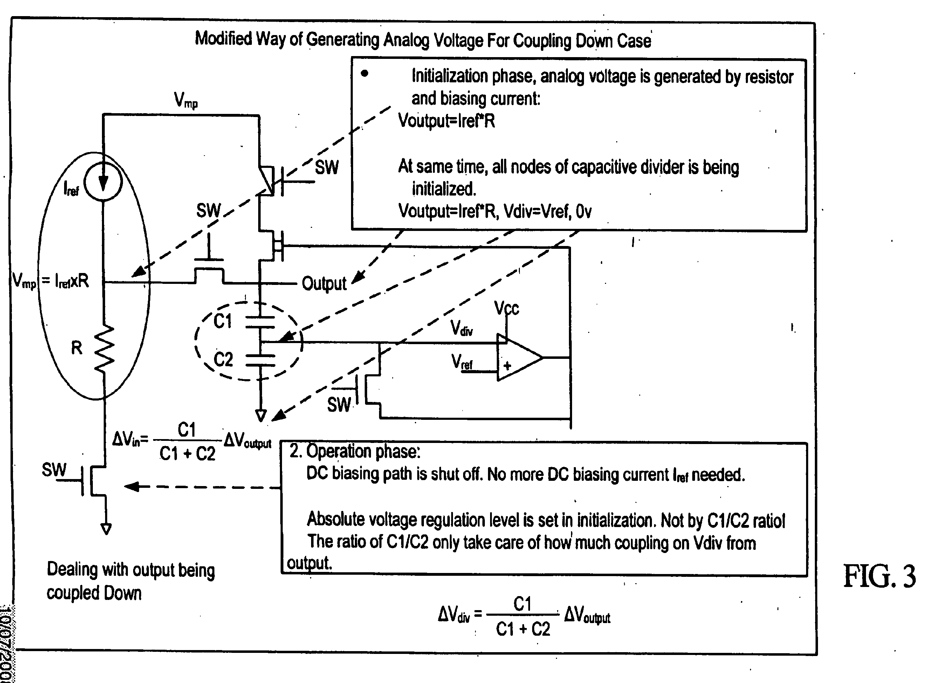

Figure 3 shows a first sample embodiment of a new circuit, in which a conventional stage is used to set the output voltage, while a differential stage self-tunes itself by connection to the correct output voltage. Note that the output node is not necessarily connected to any external load at this time.

During the startup phase (SW driven high), the reference current Iref and the load R drive the output node to approximately IrefR. (If signal SW is well above this value, there will not be a diode drop.) Because the output of the op amp is now connected back to its input (and to node div), the op amp will drive Vdiv to be equal to Vref. Note that SW also gates a PMOS, to assure that the op amp is not able to drive the output node at this time.

After the startup phase (SW low), the IrefR stage is shut off and disconnected, so its power consumption stops. The op amp now drives a pull-up transistor to keep Vdiv=Vref, and hence can respond to changing loads on the output line very rapidly. Since Vdiv was equal to Vref during initialization, and since variations on the output node should be cancelled out by the op amp and current source, the output node will stay at the same value it had during initialization. Thus the output voltage is no longer dependent on the ratio of capacitors.

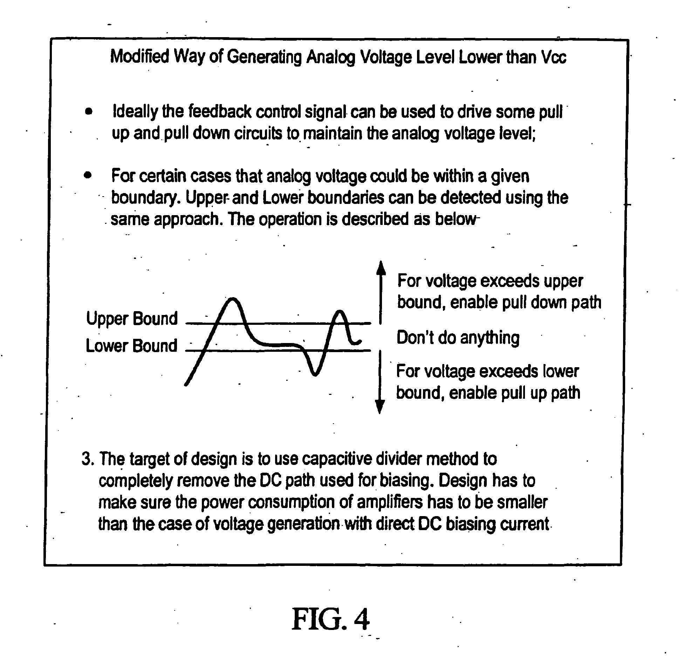

The circuit of Figure 3 shows a pull-up configuration, so this circuit would not be able to offset overvoltage at the output. One way of limiting voltage to a desired range, as shown in Figure 4, is to combine a pull-up active stage with an analogous pull-down active stage. However, it is preferable that the two stages do not have the same setpoint, for stability.

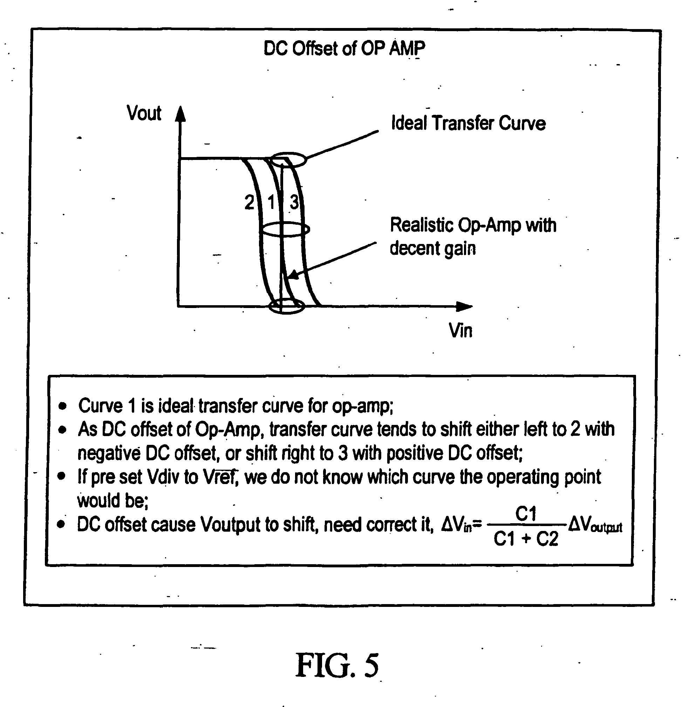

Figure 5 shows a family of op amp transfer curves. The ideal op amp can be thought of as an infinite-gain differential amplifier, so the ideal transfer curve would show a step function at the output=input point. However, a realistic op amp transfer curve will have some curvature, as do the three parallel curves shown.

These curves are parallel because they illustrate an inherent difficulty of op amps, namely uncertain DC offset. As the three oval blobs show, merely setting the input voltage does not tell us which operating curve is the correct one. This makes a difference in the circuit of Figure 2, because the DC offset voltage, multiplied by the capacitor ratio, translates to a DC error component on the output node.

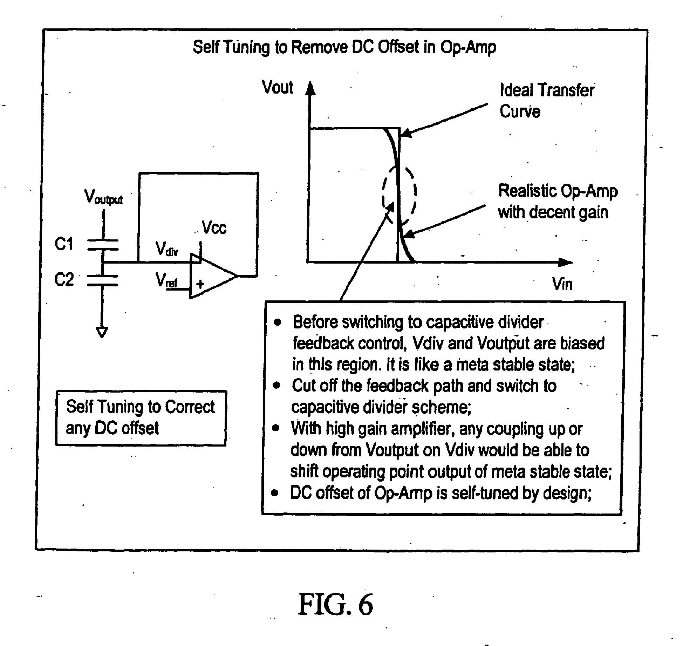

Figure 6 shows how the self tuning effect of a circuit like that of Figure 3 sets a desired operating point, and eliminates the bad effects of DC offset and capacitor ratio. The dotted line shows how the op amp has been forced to a metastable starting point on its operating curve; this assures that the op amp will respond optimally to transient loading on the output node. The uncertain DC offset of the op amp has been cancelled out.

As will be recognized by those skilled in the art, the innovative concepts described in the present application can be modified and varied over a tremendous range of applications, and accordingly the scope of patented subject matter is not limited by any of the specific exemplary teachings given- It is intended to embrace all such alternatives, modifications and variations that fall within the scope of the appended claims.

For example, additional feedback relations can be added into the illustrated circuit topology if desired, or other conditioning superimposed if desired.

For another example, pass gates can be used if needed to avoid diode drops.

For another example, other circuit topologies can be used to set the correct output value during the precharge phase.

For another example, the timing relations do not have to be as simple as those described above. Optionally some skew and/or gap in timing between the two preset gates and start of steady-state driver operation, or the different transistors which are all shown gated by SW can be skewed from each other.

For another example, the precharge phase can be run repeatedly, to avoid long-term drift in the output voltage.

None of the description in the present application should be read as implying that any particular element, step, or function is an essential element which must be included in the claim scope: THE SCOPE OF PATENTED SUBJECT MATTER IS DEFINED ONLY BY THE ALLOWED CLAIMS.

## Claims

1. A method for controlling a voltage in a circuit comprising an output connection (Output), a differential amplifier and a capacitive divider (C₁, C₂), the differential amplifier having an inverting input, a non-inverting input and an output, the capacitive divider (C₁, C₂) having a first node in common with the output connection and a second node in common with the inverting input of the differential amplifier, the method comprising:
in a first phase, operatively connecting a current-consuming voltage generation stage (I_{ref}, R) to the output connection (Output), supplying a reference voltage (V_{ref}) to the non-inverting input and feeding back an output of the differential amplifier to the inverting input;
in a second phase directing the output of the differential amplifier to the output connection (Output);
**CHARACTERISED IN THAT**:
in the second phase, the current-consuming voltage generation stage (I_{ref}, R) is turned off; and
maintaining in the second phase a voltage at the output connection (Output) by feeding a capacitively divided portion of the voltage from the output connection (Output) to the inverting input of the differential amplifier.

2. The method of Claim 1, wherein said first phase comprises a pre-charging step and the current-consuming voltage generation stage (I_{ref}, R) uses a resistor (R).

3. The method of Claim 2, wherein said pre-charging step passes a known current (I_{ref}) through the resistor.

4. The method of any preceding claim, wherein said differential amplifier is operatively connected through a current mirror to drive said output connection.

5. The method of any of Claims 1 to 3, wherein said differential amplifier is operatively connected to control a current source which drives said output connection.

6. A circuit comprising:
a differential amplifier having a first input, a second input, and an output;
an output node (Output),
a capacitive divider (C₁, C₂) having a first node in common with the output node (Output), and a second node in common with the second input, wherein in a first operational phase of the circuit the output is connected to the second input;
**CHARACTERISED IN THAT**:
the first input is arranged to receive a reference voltage level V_{ref});
in the first operational phase of the circuit, the output node (Output) is configured to be charged by a pre-charge circuit (I_{ref}, R) to an output voltage level, and in a second operation phase of the circuit, the pre-charge circuit (I_{ref}, R) is shut off; and
in the first operational phase of the circuit, the differential amplifier is adapted to drive the second node to the reference voltage level (V_{ref}), and in the second operational phase of the circuit, the circuit is configured to maintain a voltage level at the second node at the reference voltage level (V_{ref}) with feedback from the differential amplifier via the capacitive divider (C₁, C₂).

7. The circuit of Claim 6 wherein the pre-charge circuit (I_{ref}, R) comprises a current source (I_{ref}) and a resistor (R).

8. The circuit of Claim 6 wherein the capacitive divider (C₁, C₂) comprises a first capacitor (C1) having a capacitance C1 and a second capacitor (C2) having a capacitance C2, wherein a ratio of a voltage at the second node to the output voltage level is C1/(C1+C2).

9. The circuit of Claim 6 further comprising a pull-up stage in communication with a voltage source and the output node, the pull-up stage configured to be driven by the differential amplifier in response to changes in an output load.

10. The circuit of Claim 6 further comprising a switch (SW) for connecting the output to the second input.

11. The circuit of Claim 6 further comprising a switch for connecting the output node to the pre-charge circuit.

12. The circuit of Claim 6 further comprising a switch to shut-off the pre-charge circuit.

13. The circuit of Claim 6 further comprising a pull-up stage and a pull-down stage in communication with the output node, wherein the pull-up and pull-down stages are configured to limit a voltage at the output node within a desired range.

14. The circuit of Claim 13 wherein pull-up stage comprises a transistor.

## Patentansprüche

1. Verfahren zum Einstellen einer Spannung in einem Schaltkreis, der einen Ausgangsanschluss (Output), einen Differenzialventärker und einen kapazitiven Teiler (C₁, C₂) beinhaltet, wobei der Differenzialverstärker einen invertierenden Eingang, einen nicht invertierenden Eingang und einen Ausgang aufweist und der kapazitive Teiler (C₁, C₂) einen ersten, mit dem Ausgangsanschluss gemeinsamen Knoten, und einen zweiten, mit dem invertierenden Eingang des Differenzialverstärkers gemeinsamen Knoten aufweist und wobei das Verfahren
in einer ersten Phase das Herstellen einer Wirkverbindung einer stromaufnehmenden Spannungserzeugungsstufe (I_{ref}, R) mit dem Ausgangsanschluss (Output), das Anlegen einer Referenzspannung (V_{ref}) an den nicht invertierenden Eingang und das Rückführen eines Ausgangs des Differenzialverstärkers an den invertierenden Eingang sowie
in einer zweiten Phase das Anlegen des Ausgangs des Differenzsignalverstärkers an den Ausgangsanschluss (Output)
umfasst und **dadurch gekennzeichnet ist, dass**
in der zweiten Phase die stromaufnehmende Spannungserzeugungsstufe (I_{ref}, R) abgeschaltet ist und
in der zweiten Phase durch Einspeisen eines kapazitiv geteilten Anteils der Spannung aus dem Ausgangsanschluss (Output) an den invertierenden Eingang des Differenzialverstärkers eine Spannung am Ausgangsanschluss (Output) aufrecht erhalten wird.

2. Verfahren nach Anspruch 1, worin die erste Phase einen Vorladeschritt beeinhaltet und die stromaufnehmende Spannungserzeugungsstufe (I_{ref}, R) mit einem Widerstand (R) arbeitet.

3. Verfahren nach Anspruch 2, worin der Vorladeschritt einen bekannten Strom (I_{ref}) durch den Widerstand sendet.

4. Verfahren nach irgendeinem der vorhergehenden Ansprüche, worin der Differenzialverstärker zum Speisen des Ausgangsanschlusses durch einen Stromspiegel in Wirkverbindung steht.

5. Verfahren nach einem der Ansprüche 1 bis 3, worin der Differenzialverstärker zum Einstellen einer Stromquelle, die den Ausgangsanschluss speist, in Wirkverbindung steht.

6. Schaltung, welche
einen Differenzialverstärker mit einem ersten Eingang, einem zweiten Eingang und einem Ausgang,
einen Ausgangsknoten (Output),
einen kapazitiven Teiler (C₁, C₂), welcher einen ersten, mit dem Ausgangsknoten (Output) gemeinsamen Knoten und einen zweiten mit dem zweiten Eingang gemeinsamen Knoten aufweist und bei welchem in einer ersten Betriebsphase der Schaltung der Ausgang mit dem zweiten Eingang in Verbindung steht,
beinhaltet und **dadurch gekennzeichnet ist, dass**
der erste Eingang dazu geeignet ist, einen Referenzspannungspegel (V_{ref}) zu empfangen,
in der ersten Betriebsphase der Schaltung der Ausgangsknoten (Output) dazu konfiguriert ist, durch einen Vorladekreis (I_{ref}, R) auf einen Ausgangsspannungspegel geladen zu werden, und in einer zweiten Betriebsphase der Schaltung der Vorladekreis (I_{ref}, R) abgeschaltet ist und
in der ersten Betriebsphase der Schaltung der Differenzialverstärker dazu geeignet ist, den zweiten Knoten auf den Referenzspannungspegel (V_{ref}) zu treiben, und die Schaltung dazu konfiguriert ist, in der zweiten Betriebsphase der Schaltung an dem zweiten Knoten mit Rückführung von dem Differenzialverstärker über den kapazitiven Teiler (C₁, C₂) einen Spannungspegel auf Höhe des Referenzspannungspegels (V_{ref}) aufrechtzuerhalten.

7. Schaltung nach Anspruch 6, worin der Vorladekreis (I_{ref}, R) eine Stromquelle (I_{ref}) und einen Widerstand (R) beinhaltet.

8. Schaltung nach Anspruch 6, worin der kapazitive Teiler (C₁, C₂) einen ersten Kondensator (C1) mit einer Kapazität C1 und einen zweiten Kondensator (C2) mit einer Kapazität C2 umfasst und worin ein Verhältnis einer Spannung an dem zweiten Knoten zum Ausgangsspannungspegel C1/(C1+C2) beträgt.

9. Schaltung nach Anspruch 6, welche weiterhin eine Spannungserhöhungsstufe in übertragender Verbindung mit einer Spannungsquelle und dem Ausgangsknoten umfasst, wobei die Spannungserhöhungsstufe derart konfiguriert ist, dass sie als Antwort auf Veränderungen einer Last am Ausgang durch den Differenzialverstärker gespeist wird.

10. Schaltung nach Anspruch 6, welche weiterhin einen Schalter (SW) zum Verbinden des Ausgangs mit dem zweiten Eingang umfasst.

11. Schaltung nach Anspruch 6, welche weiterhin einen Schalter zum Verbinden des Ausgangsknotens mit dem Vorladekreis umfasst.

12. Schaltung nach Anspruch 6, welche weiterhin einen Schalter zum Absperren des Vorladekreises umfasst.

13. Schaltung nach Anspruch 6, welche weiterhin eine Spannungserhöhungsstufe und eine Spannungsminderungsstufe in übertragender Verbindung mit dem Ausgangsknoten umfasst, wobei die Spannungserhöhungsstufe und die Spannungsminderungsstufe derart konfiguriert sind, dass sie eine Spannung an dem Ausgangsknoten innerhalb eines gewünschten Bereichs begrenzen.

14. Schaltung nach Anspruch 13, worin die Spannungserhöhungsstufe einen Transistor beinhaltet.

## Revendications

1. Procédé pour commander une tension dans un circuit comprenant une connexion de sortie (Output), un amplificateur différentiel et un diviseur capacitif (C₁, C₂), l'amplificateur différentiel ayant une entrée d'inversion, une entrée non-inversion et une sortie, le diviseur capacitif (C₁, C₂) ayant un premier noeud en commun avec la connexion de sortie et un deuxième noeud en commun avec l'entrée d'inversion de l'amplificateur différentiel, le procédé comprenant :
dans une première phase, la connexion fonctionnelle d'un étage de génération de tension consommatrice de courant (I_{ref}, R) à la connexion de sortie (Output), l'application d'une tension de référence (V_{ref}) à l'entrée non-inversion et le retour d'une sortie de l'amplificateur différentiel à l'entrée d'inversion ;
dans une deuxième phase l'orientation de la sortie de l'amplificateur différentiel vers la connexion de sortie (Output) ;
**caractérisé en ce que** :
dans la deuxième phase, l'étage de génération de tension consommatrice de courant (I_{ref}, R) est désactivé ; et
le maintien dans la deuxième phase d'une tension à la connexion de sortie (Output) en chargeant une partie divisée de façon capacitive de la tension provenant de la connexion de sortie (Output) vers l'entrée d'inversion de l'amplificateur différentiel.

2. Procédé de la revendication 1, dans lequel ladite première phase comprend une étape de précharge et l'étage de génération de tension consommatrice de courant (I_{ref}, R) utilise une résistance (R).

3. Procédé de la revendication 2, dans lequel ladite étape de précharge fait passer un courant connu (I_{ref}) à travers la résistance.

4. Procédé de l'une quelconque des revendications précédentes, dans lequel ledit amplificateur différentiel est fonctionnellement connecté par l'intermédiaire d'un miroir de courant pour alimenter ladite connexion de sortie.

5. Procédé de l'une quelconque des revendications 1 à 3, dans lequel ledit amplificateur différentiel est fonctionnellement connecté pour commander une source de courant qui alimente ladite connexion de sortie.

6. Circuit comprenant:
un amplificateur différentiel ayant une première entrée, une deuxième entrée, et une sortie ;
un noeud de sortie (Output),
un diviseur capacitif (C₁, C₂) ayant un premier noeud en commun avec le noeud de sortie (Output), et un deuxième noeud en commun avec la deuxième entrée, où, dans une première phase opérationnelle du circuit, la sortie est connectée à la deuxième entrée ;
**caractérisé en ce que**
la première entrée est agencée pour recevoir un niveau de tension de référence V_{ref};
dans la première phase opérationnelle du circuit, le noeud de sortie (Output) est configuré pour être chargé par un circuit de précharge (I_{ref}, R) à un niveau de tension de sortie, et dans une deuxième phase opérationnelle du circuit, le circuit de précharge (I_{ref}, R) est désactivé ; et
dans la première phase opérationnelle du circuit, l'amplificateur différentiel est adapté pour propulser le deuxième noeud au niveau de tension de référence (V_{ref}), et dans la deuxième phase opérationnelle du circuit, le circuit est configuré pour maintenir un niveau de tension au deuxième noeud au niveau de tension de référence (V_{ref}) avec un retour de l'amplificateur différentiel via le diviseur capacitif (C₁, C₂).

7. Circuit de la revendication 6 dans lequel le circuit de précharge (I_{ref}, R) comprend une source de courant (I_{ref}) et une résistance (R).

8. Circuit de la revendication 6 dans lequel le diviseur capacitif (C₁, C₂) comprend un premier condensateur (C1) ayant une capacité C1 et un deuxième condensateur (C2) ayant une capacité C2, dans lequel un rapport d'une tension au deuxième noeud au niveau de tension de sortie est C1/(C1+C2).

9. Circuit de la revendication 6 comprenant en outre un étage de rappel vers le haut en communication avec une source de tension et le noeud de sortie, l'étage de rappel vers le haut étant configuré de manière à être alimenté par l'amplificateur différentiel en réponse aux changements d'une charge de sortie.

10. Circuit de la revendication 6 comprenant en outre un commutateur (SW) pour connecter la sortie à la deuxième entrée.

11. Circuit de la revendication 6 comprenant en outre un commutateur pour connecter le noeud de sortie au circuit de précharge.

12. Circuit de la revendication 6 comprenant en outre un commutateur pour désactiver le circuit de précharge.

13. Circuit de la revendication 6 comprenant en outre un étage de rappel vers le haut et un étage de rappel vers le bas en communication avec le noeud de sortie, les étages de rappel vers le haut et de rappel vers le bas étant configurés pour limiter une tension au noeud de sortie dans une plage souhaitée.

14. Circuit de la revendication 13 dans lequel l'étage de rappel vers le haut comprend un transistor.
